# EUROPEAN PATENT APPLICATION

(11) **EP 3 634 096 A1**
(43) Date of publication of application: **08.04.2020**
(21) Application number: 18198224.0
(22) Date of filing: 02.10.2018
(51) Int. Cl.: H05K 7/20, H01L 23/40

(54) **POWER INVERTER**

(71) Applicant: Mahle International GmbH, 70376 Stuttgart (DE)
(72) Inventor: BOZIC, Jernej, 5250 Solkan (SI); BUCIK, Silvan, 5250 Solkan (SI); STOLFA, Danijel, 5250 Solkan (SI)
(74) Representative: BRP Renaud & Partner mbB Rechtsanwälte Patentanwälte Steuerberater

(57) **Abstract**

The invention relates to a power inverter (10) for an electrical machine (80). The power inverter (10) comprises a housing (20) having a central longitudinal axis (30) and a heat sink (210). A plurality of power semiconductors (41) are arranged in the housing (20), and cooperate with a coupling surface (210a) of the heat sink (210) in a thermally conductive manner.

According to the invention, the coupling surface (210a) of the heat sink (210) extends perpendicularly to a power circuit board (40) which carries the power semiconductors (41). The power inverter (10) further incorporates a preloading arrangement (60) having at least one resilient element (630) and one force-applying element (610), wherein the at least one resilient element (630) is preloaded between at least one of the power semiconductors (41) and the force-applying element (610), and compresses at least one of the power semiconductors (41) against the coupling surface (210a) of the heat sink (210).

The invention further relates to an electrical machine (80) having said power inverter (10).

## Description

The invention relates to a power inverter for an electrical machine, according to the preamble of Claim 1. The invention further relates to an electrical machine having said power inverter.

In a generic power inverter, a direct current is converted into a three-phase alternating current. The power inverter can be employed for the propulsion of an electrical machine for example in a motor vehicle, wherein the direct current is tapped from a battery, is converted into an alternating current, and is fed to the electrical machine. The electrical machine can be a permanently excited or separately excited synchronous machine, an asynchronous machine or another type of electrical machine.

For the conversion of a direct current into an alternating current, the power inverter customarily incorporates a power circuit board having a plurality of capacitors and a plurality of power semiconductors, which are electrically interconnected. In operation, the power inverter generates a large quantity of heat energy, and the power semiconductors in particular require intensive cooling. To this end, the power circuit board is connected to a heat-conducting cooling plate in a thermally conductive manner, and the heat generated in the power semiconductors is evacuated via the power circuit board and via a layer of insulation to the cooling plate.

The object of the invention is the disclosure of an alternative form of embodiment of a power inverter of the generic type, in which the cooling of the power inverter is improved. A further object of the invention is the provision of an electrical machine having a power inverter which is effectively cooled.

According to the invention, these objects are fulfilled by the subject matter of the independent claims. Advantageous forms of embodiment are the subject matter of the dependent claims.

The present invention is based upon the general concept, whereby the power semiconductors in a power inverter for an electrical machine which are to be cooled are directly or immediately coupled to a heat sink. The power inverter thus comprises a housing having a central longitudinal axis and a heat sink. In the housing, moreover, a plurality of power semiconductors are arranged, which cooperate with a coupling surface of the heat sink in a thermally conductive manner. According to the invention, the coupling surface of the heat sink with which the power semiconductors are in contact extends perpendicularly to a power circuit board which carries the power semiconductors. The power inverter further incorporates a preloading arrangement having at least one resilient element and one force-applying element. The at least one resilient element is pre-loaded between at least one of the power semiconductors and the force-applying element, and compresses at least one of the power semiconductors against the coupling surface of the heat sink.

In the power inverter according to the invention, at least one of the power semiconductors is compressed against the coupling surface of the heat sink, and is thus in direct and immediate contact with the latter. It is understood that a heat-transmitting and perhaps insulating layer can be arranged between the power semiconductors and the heat think. Heat generated in the respective power semiconductor can be directly and immediately evacuated to the heat sink, and from thence further outwards. Specifically, the cooling of the respective power semiconductor in the power converter according to the invention can be improved as a result, as no additional layers or only a heat-conducting and perhaps insulating layer are arranged between the respective power semiconductor and the heat sink. The preloading arrangement compresses the respective power semiconductor against the heat sink, such that the power semiconductor is also protected against undesirable vibrations. The heat sink can thus be formed of a thermally conductive material - for example, of a metal such as aluminium - such that thermal conduction between the respective power semiconductor and the heat sink, and between the heat sink and the surrounding environment, is improved.

Advantageously, between the coupling surface of the heat sink and at least one of the power semiconductors, a heat-conducting layer can be secured in contact with the latter. The heat-conducting layer thus lies in direct contact, on one side, with the respective power semiconductor and, on the other side, with the coupling surface of the heat sink, and can thus improve thermal conduction between the respective power semiconductor and the heat sink. The heat-conducting layer is preferably a heat-conducting film or a heat-conducting paste, or a casting compound of a heat-conducting material. The heat-conducting layer can further insulate the power semiconductors from the heat sink.

In an advantageous further development of the power inverter according to the invention, it is provided that the at least one resilient element is an resilient clamp with two preferably flat prongs, which are connected to each other by means of a bearing section. Advantageously, one prong of the at least one resilient clamp can then engage with at least one of the power semiconductors, and the other prong of the at least one resilient clamp can engage with the force-applying element in a pre-loaded arrangement. In this manner, the power semiconductor can be compressed against the coupling surface of the heat sink, and is thus directly coupled to the heat sink in a thermally conductive manner. In order to vary the compression force applied by the respective resilient clamp to at least one of the power semiconductors, one prong can assume a different length, in relation to the other prong.

In an advantageous further development of the preloading arrangement, it is provided that the preloading arrangement incorporates at least one carrier, which is arranged on the heat sink in parallel with the power circuit board, and is oriented in parallel with at least one of the power semiconductors. The at least one resilient element is thus supported on the at least one carrier, and compresses at least one of the power semiconductors against the coupling surface of the heat sink. Advantageously, the at least one resilient element can be configured as a resilient clamp, and the at least one carrier as a carrier shaft which engages on both sides with a bearing slot in the heat sink. The resilient clamp, on its bearing section, can then be fitted to the carrier shaft - for example by means of a clip-on connection. Advantageously, the carrier shaft can constitute an axis of rotation of the at least one resilient clamp, and the resilient clamp can be arranged to rotate about the axis of rotation on the carrier shaft. The carrier shaft is oriented in parallel with at least one of the power semiconductors, and secures the respective resilient clamp between at least one of the power semiconductors and the force-applying element. Appropriately, one prong is pressed against at least one of the power semiconductors, and the other prong is pressed against the force-applying element, such that the power semiconductor is compressible against the coupling surface of the heat sink, and can thus be directly coupled to the heat sink in a thermally conductive manner.

Advantageously, it can be provided that the force-applying element is a clamping plate, which is fitted to the at least one resilient element axially to the central longitudinal axis vis-à-vis the power semiconductors, and with which the at least one resilient element cooperates, radially to the central longitudinal axis. Advantageously, where the respective resilient element is configured as an resilient clamp which is supported on a carrier shaft, the execution of the clamping plate can be simplified. For example, the clamping plate can incorporate a clamping edge which is oriented in parallel with the respective carrier shaft, wherein one prong of the at least one resilient clamp engages with at least one of the power semiconductors, and the other prong of the at least one resilient clamp engages with the clamping edge of the clamping plate, in a pre-loaded arrangement. Alternatively or additionally, the clamping plate can incorporate at least one stop lug, which engages with the bearing section of the at least one resilient clamp, parallel to the respective carrier shaft. The at least one resilient clamp can thus be attached to the carrier shaft in a non-displaceable manner, and the respective power semiconductor is securely coupled to the housing wall in a thermally conductive manner. The stop lug can, moreover, secure the at least one carrier shaft axially to the power semiconductors. The clamping plate can, moreover, alternatively or additionally incorporate a fixing edge, which secures the bearing section of the at least one resilient clamp to the respective carrier shaft, axially to the central longitudinal axis and to the power semiconductors. The fixing edge prevents any unwanted detachment of the at least one resilient clamp from the carrier shaft and secures the thermally conductive contact between the respective power semiconductor and the heat sink.

In order to constitute a large-surface thermally conductive coupling between the power semiconductors and the heat sink, it can advantageously be provided that, on the coupling surface of the heat sink, at least one planar clamping section is configured for at least one of the power semiconductors. The planar power semiconductor can then assume a large-surface thermally conductive contact with the planar clamping section configured on the coupling surface of the heat sink, thereby improving heat conduction between the respective power semiconductor and the heat sink. Moreover, a plurality of planar clamping sections can be configured in the circumferential direction, distributed over the coupling surface of the heat sink. Accordingly, a plurality of power semiconductors can assume a large-surface contact with the coupling surface of the heat sink, and can be configured in a space-saving arrangement. Preferably, three planar clamping sections are configured in the circumferential direction, distributed over the coupling surface of the heat sink. To each clamping section, a half-bridge circuit can be assigned, in which two of the power semiconductors, or a whole-number multiple thereof, are electrically interconnected.

In a further development of the preloading arrangement, it is advantageously provided that, for each of the clamping sections, a respective carrier is provided and, for each of the power semiconductors in the respective clamping section, a respective resilient element is provided. In the respective clamping section, the individual power semiconductors are compressed against the coupling surface of the heat sink by the individual resilient elements. The individual resilient elements are supported on the respective carrier, and are thus arranged between the individual power semiconductors and the force-applying element. The individual resilient elements thus compress the individual power semiconductors against the coupling surface of the heat sink, and the individual power semiconductors are directly coupled to the heat sink in a thermally conductive manner. The individual power semiconductors are, moreover, compressible against the coupling surface of the heat sink with an equal compression force, thereby permitting the achievement of uniform heat conduction and a uniform cooling of the individual power semiconductors.

If the respective resilient elements are configured as resilient clamps supported on a carrier shaft, and the force-applying element is configured as a clamping plate, the individual resilient clamps or, alternatively, an entire row of individual resilient clamps can be secured on the carrier shaft in a non-displaceable manner by means of the stop lugs on either side of the clamping plate. By means of the fixing edge of the clamping plate, moreover, the individual resilient clamps can also be secured axially to the central longitudinal axis. The prongs of the individual resilient clamps are thus pre-loaded between the clamping edge of the clamping plate and the individual power semiconductors, such that the individual power semiconductors are compressed against the coupling surface of the heat sink in the respective clamping section. One of the resilient clamps on the carrier shaft is assigned to each of the power semiconductors, such that the individual power semiconductors are compressed against the coupling surface of the heat sink with an equal compression force. As a result, advantageously, uniform heat conduction between the individual power semiconductors and the heat sink and a uniform cooling of the individual power semiconductors can be achieved.

In a particularly advantageous configuration of the power inverter, it can be provided that the power semiconductors are secured in an edge region of a power circuit board, perpendicularly to the latter. The power circuit board can thus be fitted in the housing, perpendicularly to the central longitudinal axis, such that the power semiconductors in the housing extend axially to the central longitudinal axis. Moreover, a plurality of capacitors can be fitted to the power circuit board, perpendicularly to the power circuit board, and oriented towards the force-applying element. The force-applying element can incorporate at least one through opening, into which the capacitors project axially. Additionally, on the force-applying element, a capacitor retaining plate, which is averted from the power circuit board, can be fitted or can be integrally configured. The capacitor retaining plate thus positions the capacitors which project axially through the respective through opening in the force-applying element, radially to the central longitudinal axis. To this end, the capacitor retaining plate preferably incorporates location openings, in which the capacitors are radially located. As the capacitors are customarily soldered to the power circuit board, the capacitor retaining plate can prevent any interruption of the rigid and brittle soldered contacts on the power circuit board associated with vibrations or oscillations.

Advantageously, it can be provided that a control board is fitted between the power circuit board and a housing base, which is averted from the force-applying element, perpendicularly to the central longitudinal axis. The control board is electrically insulated from the housing base and from the power circuit board, and is preferably arranged with a clearance to the latter. To this end, for example, spacing screws can be provided, which are fitted on one side to the housing base and on the other side to the control board, and maintain a clearance between the latter and the housing base. The control board can, moreover, incorporate an electric power connector, which is averted from the power circuit board and is brought out to the exterior through a terminal opening in the housing base. By means of the electric power connector, the control board and, correspondingly, the power inverter can be connected to an external DC voltage source and/or to an external control circuit in a signal-transmitting arrangement.

The control board can, moreover, incorporate a positive pole contact terminal and a negative pole contact terminal which, by means of a respective conductor, electrically bond the control board to the power circuit board, preferably in the form of current-conducting studs which are routed through the power circuit board, axially to the central longitudinal axis. The positive pole contact terminal and negative pole contact terminal can appropriately be connected to the electric power connector in an electrically conductive manner, in order to conduct direct current from an external direct current source via the respective conductor to the power circuit board. The respective conductors in the form of current-conducting studs can, moreover, fit the control board with a clearance to the housing base and to the power circuit board, for which purpose the respective current conducting studs can incorporate at least one radial stop rim or a radially oriented stop moulding. The respective current-conducting studs are appropriately fitted to the housing base in an electrically insulated arrangement.

On the power circuit board, the power semiconductors can constitute a power circuit having three phase terminals, wherein the phase terminals are arranged on the power circuit board perpendicularly to the central longitudinal axis, facing a closable housing opening in the housing, and are accessible from the exterior. Advantageously, a respective phase terminal can be electrically bonded with a respective half-bridge circuit, in which two of the power semiconductors, or a whole-number multiple thereof, are electrically interconnected. The phase terminals can then extend from the respective half-bridge circuits to a contact zone, which is arranged on the closable housing opening of the housing. Via the electric power connector, the power inverter can be supplied with direct current from an external direct current source, which can be routed from the positive pole contact terminal and the negative pole contact terminal via the respective conductors to the power circuit board. A three-phase alternating current can be tapped off from the power inverter via the phase terminals. The phase terminals are accessible from the exterior through the housing opening, such that phase terminal pins of an electrical machine can be secured to phase terminals, for example by soldering. In order to protect the power circuit board and the control board against fouling, the power inverter can be provided with a cover for the closure of the housing opening. The cover can, moreover, be sealed from the exterior by means of an annular seal, such that the power circuit board and the control board are also protected against moisture.

In a preferred further development of the power inverter, it is provided that the heat sink is constituted by a housing wall which is arranged circumferentially to the central longitudinal axis, wherein the coupling surface of the heat sink corresponds to an inner surface of the housing wall. The housing and the housing wall are appropriately formed of a heat-conducting material - for example of a metal such as aluminium - in order to improve heat conduction between the respective power semiconductor and the housing wall, and between the housing wall and the environment.

In order to improve the cooling of the power semiconductors, a plurality of cooling ribs can be integrally moulded on an outer surface of the housing wall, which is averted from the inner surface. Alternatively or additionally, a plurality of cooling ribs can also be moulded on an outer surface of a housing base, which is averted from the power circuit board. The cooling ribs enlarge the external surface of the housing wall and the housing base, such that heat conduction between the housing wall, the housing base and the environment is improved. As a result, heat generated in the power semiconductors can also be evacuated more effectively. Alternatively or additionally to the cooling ribs, a cooling device can be coupled to the outer surface of the housing wall which is averted from the inner surface and/or to the outer surface of a housing base which is averted from the power circuit board, in a thermally conductive manner. The housing wall and the housing base can then be cooled by means of a cooling medium which is carried in the cooling device, and the heat generated in the power semiconductors can be effectively evacuated.

Advantageously, an electrical machine can be fitted to the power inverter, wherein a drive shaft axis of a drive shaft of the electrical machine is oriented in parallel with the central longitudinal axis. The electrical machine and the power inverter can, moreover, be arranged coaxially to each other. The electrical machine can, for example, be a permanently excited or separately excited synchronous machine, an asynchronous machine or another type of electrical machine. A machine wall closes the housing perpendicularly to the central longitudinal axis, and engages the force-applying element with the at least one resilient element, axially to the central longitudinal axis, in a pre-loaded arrangement. In this manner, the machine wall constitutes a housing cover of the power inverter, which is appropriately arranged in opposition to the housing base. The machine wall thus engages the force-applying element with the at least one resilient element, in a pre-loaded arrangement, such that the power semiconductors are compressed against the inner surface of the housing wall. As a result, specifically, additional means for the axial fixing of the force-applying element in the housing of the power inverter are omitted, and the power inverter is of a simplified and comparatively cost-effective design. Preferably, the electrical machine is fitted to the power inverter at an opposite end thereof to the drive shaft, in order to prevent any disturbance to the operation of the electrical machine. The phase terminal pins of the electrical machine are appropriately axially insertable into the power inverter, up to the phase terminals on the power circuit board, and can be electrically bonded with the latter - for example by soldering - via the housing opening in the housing wall.

In summary, the power semiconductors in the power inverter according to the invention are directly and immediately coupled to the coupling surface of the heat sink in a thermally conductive manner. Between the coupling surface of the heat sink and the respective power semiconductors, no layers or only a heat-conducting and perhaps insulating layer are arranged, such that heat conduction between the respective power semiconductors and the heat sink, and thus the cooling of the respective power semiconductors, is improved.

The invention further relates to an electrical machine having a drive shaft which is rotatable about a drive shaft axis and having a power inverter. According to the invention, the power inverter can be configured as described above. The electrical machine can, for example, be a permanently excited or separately excited synchronous machine, an asynchronous machine or another type of electrical machine. Preferably, the power inverter is configured coaxially to the electrical machine. A machine wall constitutes a housing cover of the power inverter, and closes the housing of the power inverter perpendicularly to the central longitudinal axis of the power inverter. The electrical machine is appropriately fitted to the power inverter at an opposite end thereof to the drive shaft, in order to prevent any disturbance to the operation of the electrical machine.

Further significant characteristics and advantages of the invention proceed from the sub-claims, from the drawings, and from the associated description of the figures, which refers to the drawings.

It is understood that the above-mentioned characteristics, and those described hereinafter, can be employed not only in the respective combination indicated, but also in other combinations, or in isolation, without departing from the scope of the present invention.

Preferred exemplary embodiments of the invention are represented in the drawings and are described in greater detail in the following description, wherein identical reference symbols refer to identical, similar or functionally equivalent components.

In the drawings, schematically in each case:
- Fig. 1: shows an exploded view of a power inverter according to the invention;
- Fig. 2: shows a view of the assembled power inverter, as represented in Fig. 1;
- Figs 3 and 4: show views of a control board in the power inverter represented in Fig. 1 and Fig. 2;
- Fig. 5: shows a view of a power circuit board in the power inverter represented in Fig. 1 and Fig. 2;
- Fig. 6: shows a view of a plurality of carriers and resilient clamps in a preloading arrangement of the power inverter represented in Fig. 1 and Fig. 2;
- Figs 7 and 8: show views of a clamping plate in a preloading arrangement of the power inverter represented in Fig. 1 and Fig. 2;
- Fig. 9: shows a view of a capacitor retaining plate in the power inverter represented in Fig. 1 and Fig. 2;
- Fig. 10: shows an exploded view of the power inverter represented in Fig. 1 and Fig. 2, with an electrical machine;
- Figs 11 and 12: show views of an electrical machine according to the invention, with the power inverter represented in Fig. 1 and Fig. 2.

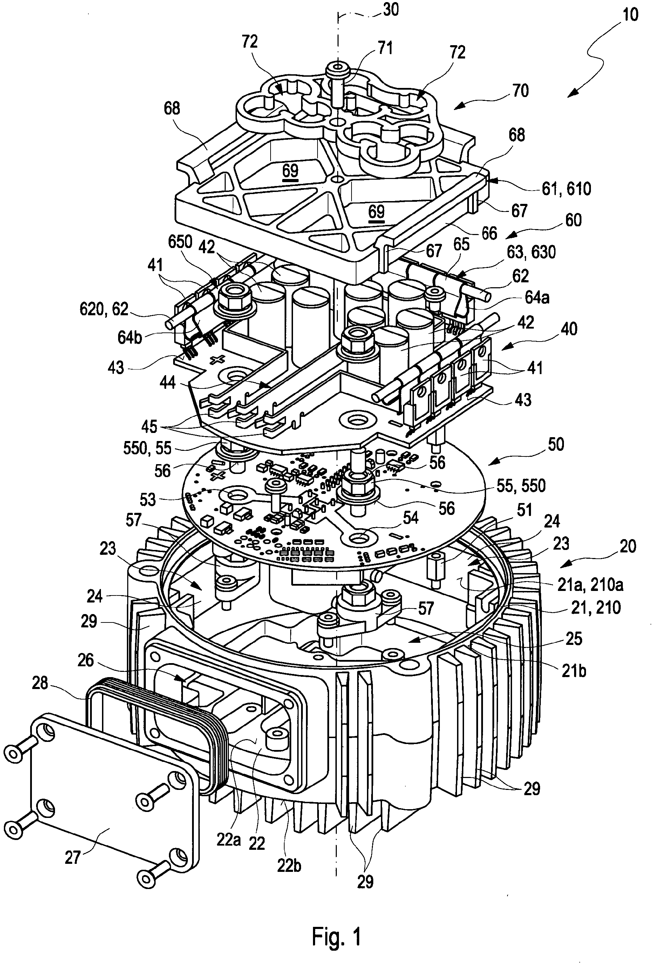

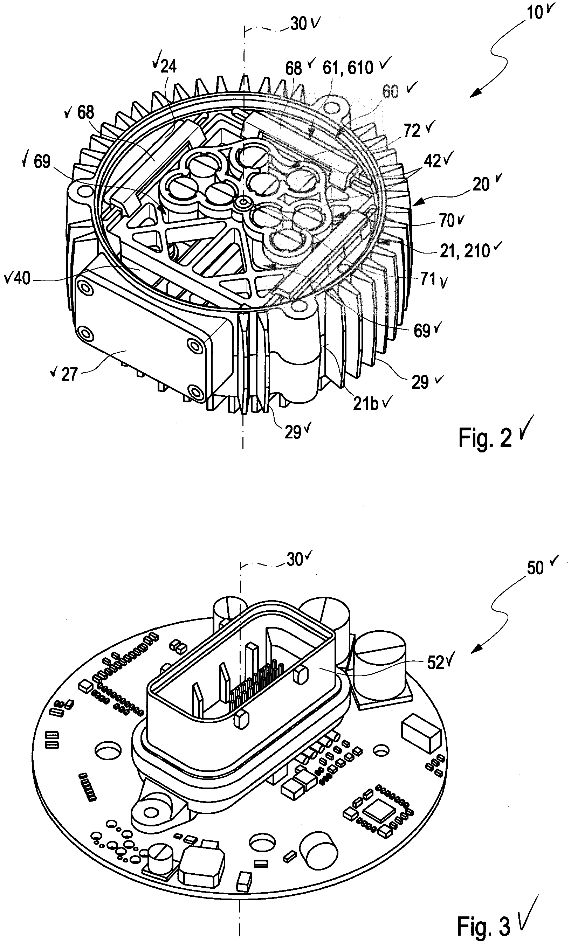

Fig. 1 shows an exploded view, and Fig. 2 shows a view of a power inverter 10 according to the invention. The power inverter 10 incorporates a housing 20 and a heat sink 210 - in this case a housing wall 21 - which extends around a central longitudinal axis 30 of the housing 20. The housing 20 further incorporates a housing base 22 which, on one side, closes the housing 20 perpendicularly to the central longitudinal axis 30. In the housing 20, a power circuit board 40 having a plurality of power semiconductors 41 and a plurality of capacitors 42 is fitted perpendicularly to the central longitudinal axis 30. Between the housing base 22 and the power circuit board 40, a control board 50 is fitted perpendicularly to the central longitudinal axis 30. The control board 50 is arranged with a clearance to the housing base 20 and to the power circuit board 40, and is electrically insulated from the latter. On the power circuit board 40, a preloading arrangement 60 is further arranged, averted from the control board 50, which incorporates a force-applying element 610, a carrier 620 and resilient elements 630. In this exemplary embodiment, the force-applying element 610 is a clamping plate 61, the carrier 620 is a carrier shaft 62, and the resilient elements 630 are resilient clamps 63. A capacitor retaining plate 70 is arranged on the clamping plate 61, averted from the power circuit board 40.

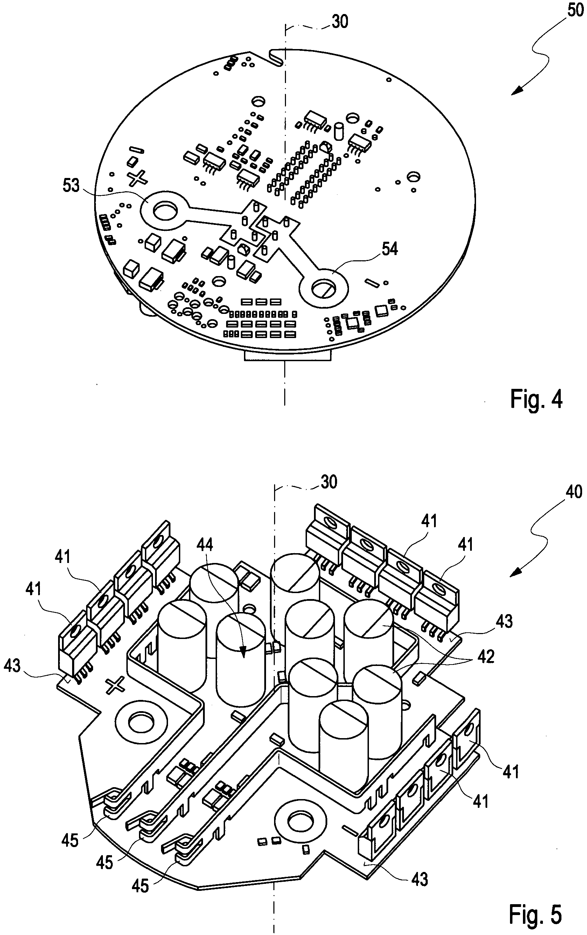

The power semiconductors 41, in an edge region 43 of the power circuit board 40, are oriented perpendicularly to the latter and in parallel with the central longitudinal axis 30, as also represented in Fig. 5. The resilient clamps 63 of the preloading arrangement 60 are pre-loaded between the power semiconductors 41 and the clamping plate 61, and compress the power semiconductors 41 against a coupling surface 210a of the heat sink 210 - in this case an inner surface 21a of the housing wall 21. As a result, the power semiconductors 41 are directly and immediately bonded with the housing wall 21, and the heat generated in the power semiconductors 41 can be directly evacuated to the housing wall 21, and from thence further outwards. As no additional layers or only a heat-conducting and perhaps insulating layer are arranged between the respective power semiconductors 41 and the housing wall 21, the cooling of the power semiconductors 41 in the power inverter 10 according to the invention is significantly improved.

The power semiconductors 41 are arranged with large-surface contact to the inner surface 21a of the housing wall 21, for which purpose the housing wall 21 incorporates planar clamping sections 23. In this exemplary embodiment, a total of three clamping sections 23, distributed in the circumferential direction, are formed in the housing wall 21, in each of which four power semiconductors 41 are coupled to the housing wall 21 in a thermally conductive manner. In order to further improve heat conduction between the power semiconductors 41 and the housing wall 21, a heat-conducting layer 24 - in this case, a heat-conducting film - is respectively arranged in contact with the inner surface 21a in the respective clamping sections 23. The heat-conducting layer 24 thus forms a direct contact, on one side with the power semiconductors 41 and on the other side with the inner surface 21a of the housing wall 21, in the respective clamping section 23.

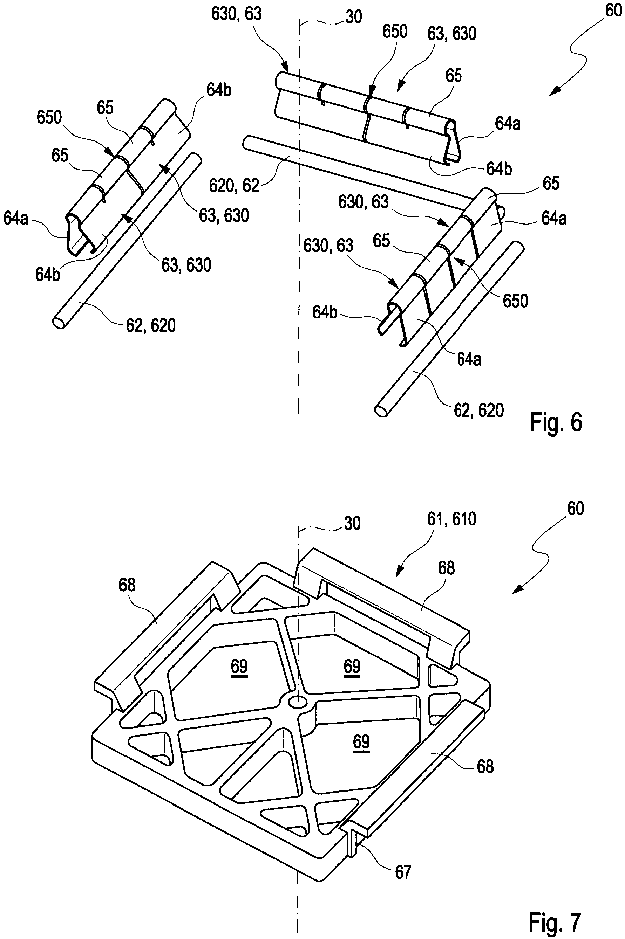

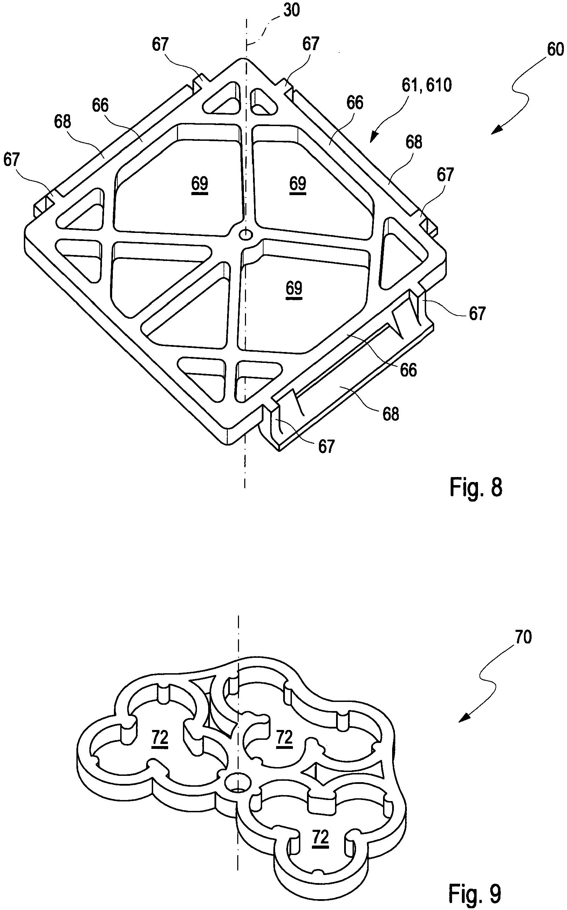

The carrier shafts 62 of the preloading arrangement 60 are fitted to the housing wall 21, and are oriented perpendicularly to the central longitudinal axis 30 and in parallel with the power semiconductors 41 in the respective clamping sections 23. As also shown in Fig. 6, each resilient clamp 63 comprises two flat prongs 64a and 64b, which are connected to each other by a bearing section 65 which is arranged on the respective carrier shaft 62. The prongs 64a and 64b can be of mutually differing lengths, in order to vary a compression force applied by the respective resilient clamps 63 to the power semiconductors 41. On the respective carrier shaft 62, the respective resilient clamps 63, at their bearing section 65, are rotatably mounted by means of a clip-on connection 650. The clamping plate 61 incorporates a clamping edge 66, which is oriented in parallel with the respective carrier shaft 62, for the pre-loading of the respective resilient clamps 63, as also represented in Fig. 7 and Fig. 8. One prong 64a engages with the adjoining power semiconductors 41, and the other separate prong 64b of the respective resilient clamp 63 applies force to the clamping edge 66 of the clamping plate 61. The clamping plate 61 further incorporates stop lugs 67, which engage with the bearing sections 65 of the resilient clamps 63, in parallel with the respective carrier shaft 62. In this manner, the resilient clamps 63 arranged on the respective carrier shaft 62 are secured to the respective carrier shaft 62 on both sides, in a non-displaceable arrangement. A fixing edge 68 of the clamping plate 61 additionally secures the bearing sections 65 of the resilient clamps 63, axially to the central longitudinal axis 30. By means of the preloading arrangement 60, the power semiconductors 41 assume a large-surface contact with the inner surface 21a of the housing wall 21, in the respective clamping sections 23, and heat conduction between the power semiconductors 41 and the housing wall 21 is improved.

The plurality of capacitors 42 on the power circuit board 40 are oriented perpendicularly to the power circuit board 40 and to the clamping plate 61, and project into through openings 69 in the clamping plate 61. The capacitor retaining plate 70 is secured to the clamping plate 61 by means of a screw 71, and incorporates a plurality of location openings 72, as also represented in Fig. 9. The capacitor retaining plate 70 positions the capacitors 42, which project axially through the respective through openings 69 in the clamping plate 61, in the location openings 72 radially to the central longitudinal axis 30, and prevents any interruption of the customarily rigid and brittle soldered contacts between the capacitors 42 and the power circuit board 40 associated with vibrations or oscillations.

The control board 50 is secured perpendicularly to the central longitudinal axis 30, between the power circuit board 40 and the housing base 22, with a clearance to the latter, by means of spacing screws 51. As also shown in Fig. 3, the control board 50 incorporates an electric power connector 52. The electric power connector 52, averted from the power circuit board 40, is brought out to the exterior via a terminal opening 25 in the housing base 22. By means of the electric power connector 52, the control board 50 and, correspondingly, the power inverter 10 can be connected to an external direct current source and/or to an external control circuit in a signal-transmitting arrangement. The control board 50 further incorporates a positive pole contact terminal 53 and a negative pole contact terminal contact 54, as also shown in Fig. 6. The positive pole contact terminal 53 and the negative pole contact terminal 54 are electrically bonded to the power circuit board 40 by means of a respective conductor 550 - in this case, current-conducting studs 55. The current-conducting studs 55 are routed through the power circuit board 40, axially to the central longitudinal axis 30, and each incorporate two stop rims 56, which extend radially and are formed on the respective current-conducting stud 55, with an axial clearance in relation to each other. The control board 50 and the power circuit board 40 thus engage with the stop rims 56 of the respective current-conducting stud 55 and, in this manner, additionally to the spacing screws 51, are secured with an axial clearance in relation to each other. The current-conducting studs 55 are fitted to an inner surface 22a of the housing base 22, by means of electrically insulating bracing elements 57.

Appropriately, the positive pole contact terminal 53 and the negative pole contact terminal 54 are connected to the electric power connector 52 in a current-conducting manner, such that direct current can be fed from an external direct current source to the power circuit board 40. The direct current delivered to the power circuit board 40 is fed to a power circuit 44, and an alternating current can be tapped off from three phase terminals 45 - cf. Fig. 5. The respective phase terminal 45 is electrically bonded to one half-bridge circuit respectively, in which power semiconductors 41 are electrically interconnected. In this exemplary embodiment, four power semiconductors 41 arranged in the respective clamping section 23 respectively constitute a half-bridge circuit. The phase terminals 45 are arranged on the power circuit board 40, perpendicularly to the central longitudinal axis 30 and opposite a housing opening 26 in the housing wall 21, such that the phase terminals 45 are also accessible from the exterior. In order to protect the power circuit board 40 and the control board 50 against fouling, the power inverter 10 incorporates a cover 27 for the closure of the housing opening 26. Moreover, the cover 27 is sealed from the exterior by means of an annular seal 28, such that the power circuit board 40 and the control board 50 are additionally protected against moisture.

In order to improve the cooling of the power inverter 10, and specifically of the power semiconductors 41, a plurality of cooling ribs 29 are integrally moulded on an outer surface 21b of the housing wall 21, which is averted from the inner surface 21a. Additionally, a plurality of cooling ribs 29 are also moulded on an outer surface 22b of the housing base 22 which is averted from the power circuit board 40. The cooling ribs 29 enlarge the outer surface 21b and 22b of the housing wall 21 and the housing base 22, such that heat conduction between the housing wall 21, and between the housing base 22 and the environment is improved.

Fig. 3 shows a view of the control board 50, from a side which faces the housing base 22, and Fig. 4 shows a view of the control board 50 from a side which faces the power circuit board 40. The control board 50 incorporates the electric power connector 52, by means of which the control board 50 and, correspondingly, the power inverter 10 are connectable to an external direct current source and/or to an external control circuit, in a signal-transmitting arrangement. The electric power connector 52 is connected, in a current-conducting manner, with the positive pole contact terminal 53 and with the negative pole contact terminal 54, by means of which direct current from an external direct current source, via current-conducting studs 55 which are not represented here, can be fed to the control board 50.

Fig. 5 shows a view of the power circuit board 40 with the power semiconductors 41 and the capacitors 42, from a side which faces the clamping plate 61. The power semiconductors 41, in the edge region 43 of the power circuit board 40, are oriented perpendicularly to the latter and in parallel with the central longitudinal axis 30, and are mutually interconnected in the power circuit 44. The respective phase terminals 45 are thus electrically bonded with a half-bridge circuit, in which power semiconductors 41 are electrically interconnected. In this exemplary embodiment, four power semiconductors 41 respectively constitute a respective half-bridge circuit. Via the phase terminals 45, an alternating current can be tapped off from the power inverter 10. Moreover, on the power circuit board 40, the capacitors 42 are oriented perpendicularly to the power circuit board 40 and are soldered to the latter.

Fig. 6 shows an exploded view of the carrier shaft 62 and the resilient clamps 63 in the preloading arrangement 60. Fig. 7 shows a view of the clamping plate 61 in the preloading arrangement 60, from a side which is averted from the resilient clamps 63, and Fig. 8 shows a view of the clamping plate 61 in the preloading arrangement 60, from a side which faces the resilient clamps 63. In this exemplary embodiment, the preloading arrangement 60 incorporates three elongated carrier shafts 62, on each of which two resilient clamps 63 are arranged for two power semiconductors 41 respectively. The resilient clamps 63, by means of the bearing sections 65, are rotatably mounted on the respective carrier shaft 62. The respective bearing sections 65 connect the two prongs 64a and 64b of the respective resilient clamps 63 to one another. If the preloading arrangement 60 is arranged on the power semiconductors 41, as represented in Fig. 1, the respective resilient clamps 63 are pre-loaded between the clamping edge 66 and the respective power semiconductors 41, and compress the respective power semiconductors 41 against the inner surface 21a of the housing wall 21. As a result, the power semiconductors 41 are coupled to the housing wall 21 in a large-surface and thermally conductive arrangement, and heat generated in the power semiconductors 41 can be evacuated to the exterior. By means of the stop lugs 67, the two resilient clamps 63 are secured to the respective carrier shaft 62 in a non-displaceable manner, and are axially secured to the carrier shaft 62 by means of the fixing edge 68. The clamping plate 61 further incorporates the through openings 69, into which the capacitors 42 on the power circuit board 40 project, as represented in Fig. 2.

Fig. 9 shows a view of the capacitor retaining plate 70, from a side which is averted from the clamping plate 61. The capacitor retaining plate 70 is fitted to the clamping plate 61, as shown in Fig. 2, and incorporates a plurality of location openings 72. The capacitor retaining plate 70 positions the capacitors 42 radially to the central longitudinal axis 30 in the location openings 72, and prevents any interruption of the customarily rigid and brittle soldered contacts between the capacitors 42 and the power circuit board 40 associated with vibrations or oscillations.

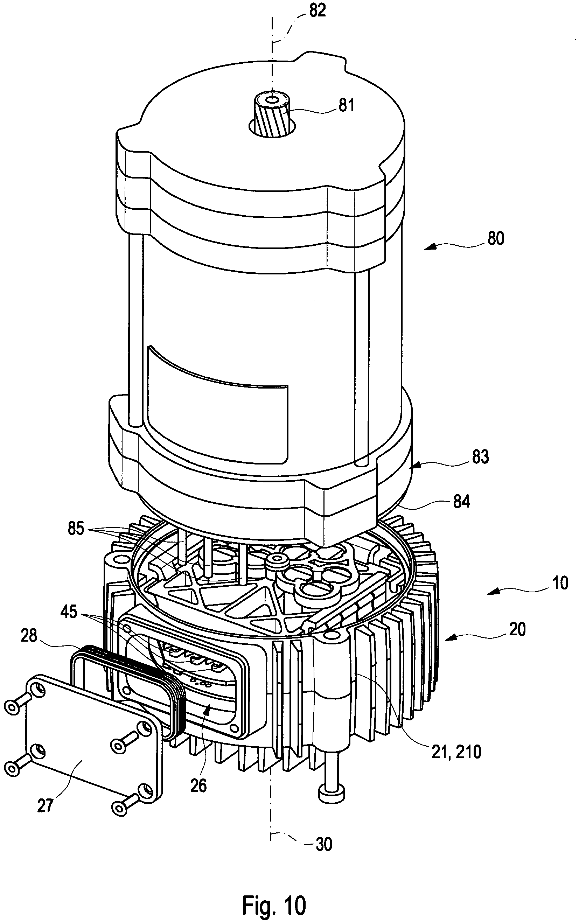

Fig. 10 shows an exploded view of the power inverter 10 and an electrical machine 80 fitted to the power inverter 10. The electrical machine 80 can, for example, be a permanently excited or separately excited synchronous machine, an asynchronous machine or another type of electrical machine. The electrical machine 80 incorporates a drive shaft 81 having a drive shaft axis 82, and is fitted to an opposing end 83 of the drive shaft 81 to the power inverter 10. The electrical machine 80 and the power inverter 10 are thus arranged coaxially to each other. A machine wall 84 of the electrical machine 80 thus closes the housing 20, in opposition to the housing base 22 and perpendicularly to the central longitudinal axis 30. Between the machine wall 84 and the carrier shaft 62, the clamping plate 61, together with the capacitor retaining plate 70, is clamped axially to the central longitudinal axis 30. Appropriately, phase terminal studs 85 of the electrical machine 80 are brought out axially through the clamping plate 61 and the capacitor retaining plate 70 to the phase terminals 45 of the power circuit board 40. Via the housing opening 26 in the housing wall 21, the phase terminal studs 85 and the phase terminals 45 are accessible from the exterior, and can be electrically bonded to one another, for example by soldering. The housing opening 26 is closed by the cover 27 with its annular seal 28.

In summary, the power semiconductors 41 in the power inverter 10 according to the invention are directly coupled to the inner surface 21a of the housing wall 21 in a thermally conductive, large-surface arrangement. No layers or only a heat-conducting and perhaps insulating layer are arranged between the inner surface 21a of the housing wall 21 and the power semiconductors 41. As a result, heat conduction between the power semiconductors 41 and the housing wall 21, and the cooling of the power semiconductors 41, are significantly improved.

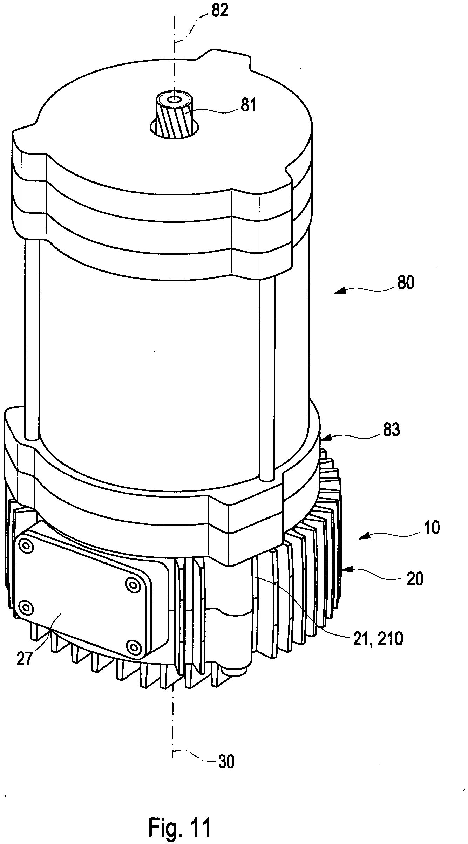

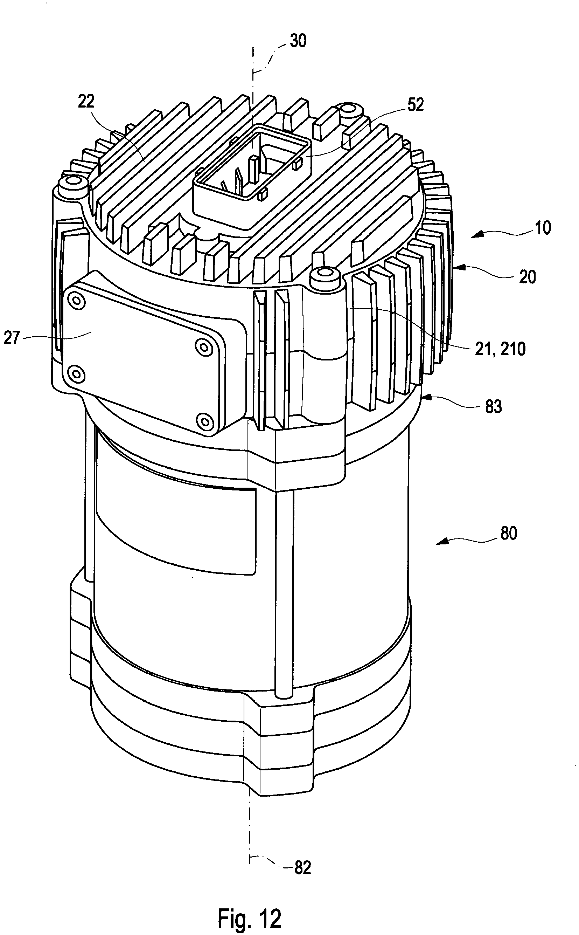

Fig. 11 and Fig. 12 show views of the electrical machine 80 according to the invention, with the power inverter 10. The electrical machine 80 can, for example, be a permanently excited or separately excited synchronous machine, an asynchronous machine or another type of electrical machine. The power inverter 10 and the electrical machine 80 are arranged coaxially to each other, wherein the power inverter 10 is fitted to the end 83 of the electrical machine 80 opposite from the drive shaft 81. Via the electric power connector 52, as shown in Fig. 12, the power inverter 10 can be supplied with direct current, and the latter is converted into an alternating current. The alternating current can be supplied to the electrical machine 80, thus driving the drive shaft 81.

## Claims

1. Power inverter (10) for an electrical machine (80),
- wherein the power inverter (10) comprises a housing (20) having a central longitudinal axis (30) and a heat sink (210), and
- wherein a plurality of power semiconductors (41) are arranged in the housing (20), and cooperate with a coupling surface (210a) of the heat sink (210) in a thermally conductive manner,
**characterized in that**
- the coupling surface (210a) of the heat sink (210) extends perpendicularly to a power circuit board (40) which carries the power semiconductors (41),
- the power inverter (10) incorporates a preloading arrangement (60) having at least one resilient element (630) and one force-applying element (610), and
- the at least one resilient element (630) is pre-loaded between at least one of the power semiconductors (41) and the force-applying element (610), and compresses at least one of the power semiconductors (41) against the coupling surface (210a) of the heat sink (210).

2. Power inverter according to Claim 1,
**characterized in that**
the at least one resilient element (630) is an resilient clamp (63) with two preferably flat prongs (64a, 64b), which are connected to each other by means of a bearing section (65).

3. Power inverter according to Claim 2,
**characterized in that**
- one prong (64a, 64b) is of a different length to the other prong (64a, 64b), as a result of which a compression force applied by the respective resilient clamp (63) to at least one of the power semiconductors (41) is variable, and/or
- one prong (64a) of the at least one resilient clamp (63) engages with at least one of the power semiconductors (41), and the other prong (64b) of the at least one resilient clamp (63) engages with the force-applying element (610) in a pre-loaded arrangement.

4. Power inverter according to one of the preceding claims,
**characterized in that**
- the preloading arrangement (60) incorporates at least one carrier (620), which is arranged on the heat sink (210) in parallel with the power circuit board (40), and is oriented in parallel with at least one of the power semiconductors (41), and
- the at least one resilient element (630) is supported on the at least one carrier (620).

5. Power inverter according to Claim 4,
**characterized in that**
- the resilient element (630) is configured as an resilient clamp (63), and the carrier (620) is configured as a carrier shaft (62) which engages on both sides with a bearing slot (211) in the heat sink (210), and
- the resilient clamp (63), on its bearing section (65), is fitted to the carrier shaft (62), preferably by means of a clip-on connection (650), wherein the carrier shaft (62) preferably constitutes an axis of rotation of the at least one resilient clamp (63).

6. Power inverter according to one of the preceding claims,
**characterized in that**
the force-applying element (610) is a clamping plate (61), which is fitted to the at least one resilient element (630) axially to the central longitudinal axis (30) vis-à-vis the power semiconductors (41), and with which the at least one resilient element (630) cooperates, radially to the central longitudinal axis (30).

7. Power inverter according to Claim 6,
**characterized in that**
- the resilient element (630) is configured as an resilient clamp (63) which is supported on a carrier shaft (62), and the clamping plate (61) incorporates a clamping edge (66) which is oriented in parallel with the respective carrier shaft (62), wherein one prong (64a) of the at least one resilient clamp (63) engages with at least one of the power semiconductors (41), and the other prong (64b) of the at least one resilient clamp (63) engages with the clamping edge (66) of the clamping plate (61), in a pre-loaded arrangement, and/or
- the resilient element (630) is configured as an resilient clamp (63) which is supported on a carrier shaft (62), and the clamping plate (61) incorporates at least one stop lug (67), which engages with the bearing section (65) of the at least one resilient clamp (63), parallel to the respective carrier shaft (62) and/or secures the at least one carrier shaft (62) axially to the power semiconductors (41), and/or
- the resilient element (630) is configured as an resilient clamp (63) which is supported on a carrier shaft (62), and the clamping plate (61) incorporates a fixing edge (68), which secures the bearing section (65) of the at least one resilient clamp (63) to the respective carrier shaft (62), axially to the power semiconductors (41).

8. Power inverter according to one of the preceding claims,
**characterized in that**
on the coupling surface (210a) of the heat sink (210), at least one planar clamping section (23) is configured for at least one of the power semiconductors (41).

9. Power inverter according to Claim 8,
**characterized in that**
a plurality of planar clamping sections (23) are configured in the circumferential direction, distributed over the coupling surface (210a) of the heat sink (210), wherein preferably three planar clamping sections (23) are configured on the coupling surface (210a) of the heat sink (210), and a half-bridge circuit is assigned to each clamping section (23), in which two of the power semiconductors (41), or a whole-number multiple thereof, are electrically interconnected.

10. Power inverter according to one of Claims 8 or 9,
**characterized in that**
- for each of the clamping sections (23), a respective carrier (620) is provided and, for each of the power semiconductors (41) in the respective clamping section (23), a respective resilient element (630) is provided on the carrier (620), and
- in the respective clamping section (23), the individual power semiconductors (41) are compressed against the coupling surface (210a) of the heat sink (210) by the individual resilient elements (630).

11. Power inverter according to one of the preceding claims,
**characterized in that**
- the power semiconductors (41) are secured in an edge region of a power circuit board (40), perpendicularly to the latter, and
- the power circuit board (40) is fitted in the housing (20), perpendicularly to the central longitudinal axis (30), such that the power semiconductors (41) in the housing (20) extend axially to the central longitudinal axis (30).

12. Power inverter according to Claim 11,
**characterized in that**
- a plurality of capacitors (42) are fitted to the power circuit board (40), perpendicularly to the power circuit board (40), and are oriented towards the force-applying element (610), and
- the force-applying element (610) incorporates at least one through opening (69), into which the capacitors (42) project axially.

13. Power inverter according to Claim 12,
**characterized in that**
- on the force-applying element (610), a capacitor retaining plate (70), which is averted from the power circuit board (40), is fitted or is integrally configured, and
- the capacitor retaining plate (70) positions the capacitors (42) which project axially through the respective through opening (69) in the force-applying element (610), radially to the central longitudinal axis (30), preferably in location openings (72).

14. Power inverter according to one of Claims 11 to 13,
**characterized in that**
- a control board (50) is fitted between the power circuit board (40) and a housing base (22), which is averted from the force-applying element (610), perpendicularly to the central longitudinal axis (30), and
- the control board (50) is electrically insulated from the housing base (22) and from the power circuit board (40), and is preferably arranged with a clearance to the latter.

15. Power inverter according to Claim 14,
**characterized in that**
- the control board (50) incorporates an electric power connector (52), which is averted from the power circuit board (50) and is brought out to the exterior through a terminal opening (25) in the housing base (22), and/or
- the control board (50) incorporates a positive pole contact terminal (53) and a negative pole contact terminal (54) which, by means of a respective conductor (550), electrically bond the control board (50) to the power circuit board (40), preferably in the form of current-conducting studs (55) which are routed through the power circuit board (40), axially to the central longitudinal axis (30).

16. Power inverter according to one of Claims 11 to 15,
**characterized in that**
- the power semiconductors (41) on the power circuit board (40) constitute a power circuit (44) having three phase terminals (45), and
- the phase terminals (45) are arranged on the power circuit board (40) perpendicularly to the central longitudinal axis (30), facing a closable housing opening (26) in the housing (20), and are accessible from the exterior.

17. Power inverter according to one of the preceding claims,
**characterized in that**
the heat sink (210) is constituted by a housing wall (21) which is arranged circumferentially to the central longitudinal axis (30), wherein the coupling surface (210a) of the heat sink (210) corresponds to an inner surface (21a) of the housing wall (21).

18. Electrical machine (80) having a drive shaft (81) which is rotatable about a drive shaft axis (82) and having a power inverter (10) according to one of the preceding claims,
- wherein the electrical machine (80) is fitted to the power inverter (10),
- wherein the drive shaft axis (82) of the drive shaft (81) of the electrical machine (80) is oriented in parallel with the central longitudinal axis (30), and
- wherein a machine wall (84) closes the housing (20) perpendicularly to the central longitudinal axis (30), and the force-applying element (610) in the housing (20), axially to the central longitudinal axis (30), engages with the resilient element (630) in a pre-loaded arrangement.
